# EUROPEAN PATENT APPLICATION

(11) **EP 1 648 041 A2**
(43) Date of publication of application: **19.04.2006**
(21) Application number: 05256381.4
(22) Date of filing: 13.10.2005
(51) Int. Cl.: H01L 51/30, H01L 51/05

(54) **Unipolar nanotube transistor using a carrier-trapping material**

(30) Priority: 13.10.2004 KR 2004081751; 13.07.2005 KR 2005063305
(71) Applicant: Samsung Electronics Co., Ltd., Suwon-si, Gyeonggi-Do (KR)
(72) Inventor: Kang, Dong-hun, yongin-si, Gyeonggi-do (KR); Park, Wan-jun, Gangnam-gu, Seoul (KR); Park, Noe-jung, Yeongtong-gu, Suwon-si, Gyeonggi-do (KR)
(74) Representative: Greene, Simon Kenneth

(57) **Abstract**

An ambipolar nanotube field effect transistor is converted to a unipolar nanotube field effect transistor by providing a carrier-trapping material such as oxygen molecules for the nanotube such as by adsorption by the nanotube or by providing a layer of material containing the carrier-trapping material adjacent to the nanotube.

## Description

### 1. Field of the Disclosure

The present invention relates to the realization of a unipolar nanotube transistor, and more particularly, a nanotube field effect transistor (NT FET) from an ambipolar nanotube field effect transistor, and especially the realization of a unipolar carbon nanotube field effect transistor (CNT FET) from an ambipolar carbon nanotube field effect transistor.

### 2. Description of the Related Art

Nanotube field effect transistors are known and demonstrate excellent electronic properties which makes them potentially valuable for a wide range of electronic applications. However, such nanotube field effect transistors typically display ambipolar electronic characteristics which makes them undesirable for use in many device applications.

As disclosed in "Ambipolar-to-Unipolar Conversion of Carbon Nanotube Transistors by Gate Structure Engineering" by Yu-Ming Lin, Joerg Appenzeller, and Phaedon Avouris which was published in Nano Letters 2004, Vol. 4, No. 5, pp. 947-950, it was known in the art that the switching behavior of carbon nanotube field-effect transistors can be improved by decreasing the gate oxide thickness. Decreasing the oxide thickness, however, is undesirable because it also results in more pronounced ambipolar transistor characteristics and higher off-currents.

The switching behavior of carbon nanotube FETs has also been improved by using dielectric materials with relatively high κ. However, the Schottky barrier contacts formed at the interface between the nanotubes and the metal in the transistor causes the scaling behavior to be different in carbon nanotube FETs than in conventional FETs.

[0001]In the article, at least one technique was disclosed to convert an ambipolar carbon nanotube transistor to a unipolar carbon nanotube transistor by using gate structure engineering. The unipolar carbon nanotube field effect transistors (CNT FETs) were obtained by providing an asymmetric gate structure with respect to the source and drain electrodes. By this process, *p-type* CNT FETs were produced from ambipolar CNT FETs.

According to the article, an ambipolar CNT FET can be made unipolar by providing a V-shaped trench through the oxide layer and into the gate along the length of the drain electrode. In the device, a carbon nanotube extends between the source and the drain. However, as noted in the article, the use of a relatively large (deep) trench is required in order to obtain satisfactory unipolar characteristics.

In the arrangement disclosed in the article, the trench has a depth which extends into the substrate. The trench provides an asymmetry between the source and the drain electrostatics and, accordingly, only part of the nanotube is electrostatically controlled through the back gate. However, the ability of such a trench to convert an ambipolar CNT FET to a unipolar CNT FET is a function of the trench width (due to fringing field effects) which makes scale reduction of such devices undesirable or problematic. The authors suggest that n-type CNT FETs may be possible by eliminating thep-type branch of an ambipolar CNT FET with a similar partial gate structure using a relatively deep trench.

Accordingly, the need remains for unipolar nanotube field effect transistors which do not require the use of gate structure engineering such as the use of a relatively large trench.

### SUMMARY OF THE DISCLOSURE

In the method of converting an ambipolar nanotube field effect transistor to a unipolar nanotube field effect transistor according to embodiments of the present invention, the nanotube field effect transistor includes a source electrode, a drain electrode, a gate, and an insulator layer which separates the gate from both the source electrode and the drain electrode. A nanotube is provided in electrical contact with the source electrode and the drain electrode with the nanotube acting as a channel region of the field effect transistor. In the method, a carrier-trapping material is provided for the nanotube.

The present invention, provides convenient method of converting an ambipolar nanotube field effect transistor to a unipolar nanotube field effect transistor provided by using a carrier-trapping material. In an exemplary embodiment of the present invention, the carrier-trapping material is oxygen molecules and the oxygen molecules is adsorbed by the nanotube.

In an exemplary method according to the present invention, the step of providing a carrier-trapping material for the nanotube includes adsorbing the carrier-trapping material by the nanotube with the carrier-trapping material being oxygen molecules.

In another exemplary method according to the present invention, the step of providing a carner-trapping material for the nanotube includes providing a layer of material between the insulator layer and the nanotube. The layer of material includes the carrier-trapping material for the nanotube and the carrier-trapping material is oxygen molecules.

In yet another exemplary method according to the present invention, the step of providing a carrier-trapping material for the nanotube includes causing a surface near the nanotube to adsorb the carrier-trapping material with the carrier-trapping material being oxygen molecules.

A exemplary method of making a field effect transistor according to the present invention also comprises the steps of providing a substrate, forming an insulative layer above the substrate, and forming a source electrode and a drain electrode above the insulative layer. A nanotube is provided between the source electrode and the drain electrode with the nanotube being in functional contact with the source electrode and the drain electrode. The nanotube acts as a channel region of the field effect transistor with a carrier-trapping material provided for the nanotube. Preferably, the carrier-trapping material is oxygen molecules and the substrate is doped to act as a back gate for the field effect transistor.

In a exemplary embodiment, the step of providing a carrier-trapping material for the nanotube includes adsorbing the carrier-trapping material by the nanotube. In another exemplary embodiment, the step of providing a carrier-trapping material for the nanotube includes providing a layer of material between the insulator layer and the nanotube with the layer of material including the carrier-trapping material for the nanotube or causing a surface near the nanotube to adsorb the carrier-trapping material.

The present invention also includes a field effect transistor which comprises a source electrode, a drain electrode, a gate, an insulator layer which separates the gate from both the source electrode and the drain electrode, and a nanotube provided in electrical contact with the source electrode and the drain electrode. The nanotube acts as a channel region of the field effect transistor and a carrier-trapping material is provided for the nanotube. In exemplary embodiments of the present invention, the carrier-trapping material is oxygen molecules and the carrier-trapping material converts the field effect transistor from being ambipolar to being unipolar

In another exemplary embodiment of the present invention, the field effect transistor further comprises an additional layer of material between the insulator layer and the nanotube. The additional layer of material contains the carrier-trapping material for the nanotube.

In yet another exemplary embodiment, the carrier-trapping material has been adsorbed by the nanotube. Preferably, the gate comprises a substrate for the field effect transistor with the insulator layer being provided above the substrate and with the source electrode, the drain electrode, and the nanotube being provided above the insulator layer. Preferably, the nanotube extends between the source electrode and the drain electrode and the substrate has been doped to act as a back gate.

### BRIEF DESCRIPTION OF THE DRAWING FIGURES

The present invention will appear more clearly from the following detailed description of several embodiments illustrated in the enclosed figures in which:
Fig. 1 is a side view of a prior art nanotube field effect transistor;
Fig. 2 is a side view of a nanotube field effect transistor according to an embodiment of the present invention;
Fig. 3 is an illustration of the adsorption of oxygen molecules by the nanotube showing the adsorption of oxygen molecules by the nanotube;
Fig. 4 is a side view of another nanotube field effect transistor embodiment according to the present invention;
Fig. 5a is a graph of the energy band gap for a conventional CNT FET;
Fig. 5b is a graph of the energy band gap for a CNT FET according to embodiments of the present invention with the gate voltage at zero;
Fig. 5c is a graph of the energy band gap for a CNT FET according to embodiments of the present invention with the gate voltage greater than zero;
Fig. 6 is a graph of energy versus position along the nanotube for electrons and holes adjacent the source electrode in a CNT FET according to embodiments of the present invention; and,
Fig. 7 is a graph of LUMO and HOMO for a CNT FET according to embodiments of the present invention.

### DETAILED DESCRIPTION OF THE INVENTION

The present invention is not intended to be limited to the description and illustrations contained herein, but may be greatly varied, especially with regard to the construction of the devices, without departing from scope of the invention as recited in the claims appended hereto.

Field effect transistors (FETs) have been provided with carbon nanotubes in a conventional FET design. The use of carbon nanotubes with FETs has generally resulted in devices having characteristics that meet or exceed current silicon based transistors which makes carbon nanotube field effect transistors (CNT FETs) interesting for a wide range of electronic applications.

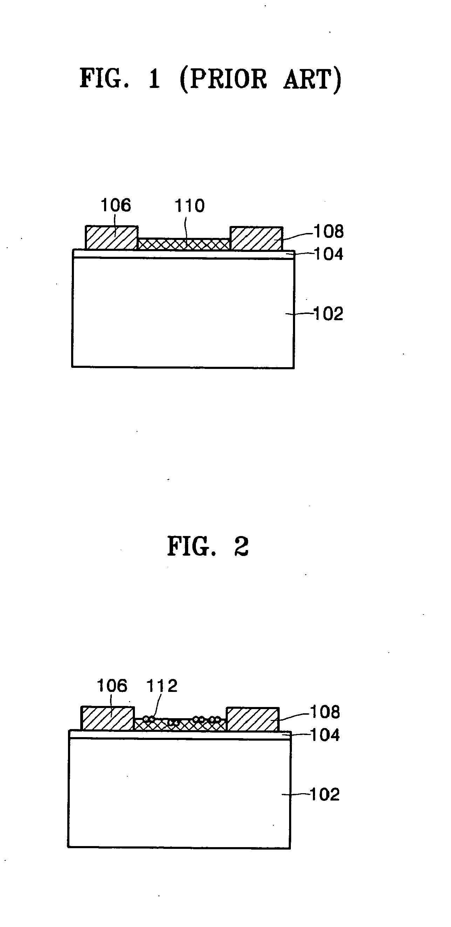

With reference to Fig. 1, a conventional carbon nanotube field effect transistor includes a layer of *p*-doped silicon 102 which forms a back gate for the device. An insulative layer 104 of silicon dioxide SiO₂ is provided above the back gate 102 with a source electrode 106 (which has been labeled "S") provided above the layer 104 of silicon dioxide. Similarly, a drain electrode 108 is also provided above the layer 104 of silicon dioxide. A carbon nanotube 110 (not drawn to scale in Fig. 1 or in the other figures for ease of understanding) is provided between the source 106 and the drain 108 with the carbon nanotube 110 in electrical contact with both the source electrode 106 and with the drain electrode 108.

In this way, the operational principal of the carbon nanotube field effect transistor (CNT FET) is generally similar to that of a conventional silicon field effect transistor. However, the physical device structure of a CNT FET of Fig. 1 is inverted (or "upside down") with respect to the typical physical device structure of a silicon FET. In other words, the source and drain are above the gate in the CNT FET rather than having the gate above the source and drain as in a conventional silicon FET.

In addition, the channel between the source and drain is provided by the carbon nanotube instead of by a single crystal of silicon. Although in the conventional CNT FET, the carbon nanotube and the source and drain are provided above the gate, it is believed that the source and drain could be below the gate or that the carbon nanotube could be buried within the device structure. Likewise, it is believed that the substrate of the CNT FET could be a layer of silicon with a separate gate provided above the source and drain or with a multi-gate arrangement. The present invention is not limited to use with the CNT FET of Fig. 1 but instead is believed to be usable with all FETs having a channel provided by a nanotube or nanowire.

In the known CNT FETs, the source and drain electrodes are typically comprised of metal(s) although the source and drain electrodes could also be comprised of polysilicon which has been doped to act as a conductor. The substrate which forms the back gate 102 is typically comprised of silicon although the substrate may be comprised of any material which provides a functional gate for the CNT FET. Likewise, the oxide layer above the gate 102 is preferably comprised of silicon dioxide although the oxide layer may be comprised of any suitable, conventional material, such as another oxide material. The oxide/insulative layer may be comprised of any suitable material having a relatively high index of dielectric constant κ. (A relatively high index of dielectric constant κ generally means a value for κ which is higher than the index of dielectric constant κ value of SiO₂ of about 4.0.) In the same way, the nanotube is preferably comprised of carbon as conventionally known although the nanotube may be comprised of other materials.

The nanotube 110 in devices according to the present invention may be a single wall carbon nanotube (SWCNT) or a double wall carbon nanotube (DWCNT) or bundles of such nanotubes, as desired. In addition, a nanowire may be used for the nanotube 110. The nanotube may comprise any material which forms a Schottky barrier, with the energy of the Schottky barrier being changeable through the presence of a carrier-trapping material such as oxygen molecules which has been adsorbed by the material. The carrier-trapping material preferably has a Lowest Unoccupied Molecular Level or LUMO which is within the band gap of the channel material, i.e., the nanotube. If the LUMO value of the carrier-trapping material is below the Fermi level of the channel material, holes would be trapped as the carriers.

As noted above, the conventional CNT FETs are ambipolar devices. Although only a typical, single gate CNT FET device is illustrated, the present invention may be used in any type of FET design which is conducive to the use of carbon nanotubes such as multigate or multiwalled FETs as well as FETs in which the CNT is suspended between the source and drain electrodes. The CNT serves as the channel instead of a single crystal of silicon. In devices according to various present invention, the CNT may also be buried in the device.

A junction typically does not exist between the CNT and the metal electrodes but instead an interface is provided between the CNT and the source electrode and the drain electrode. The gate may be provided above or below the CNT.

With reference now to Fig. 2, a nanotube field effect transistor according to the present invention corresponds generally to the conventional devices such as is shown in connection with Fig. 1. The nanotube field effect transistor of Fig. 2 includes a layer of *p-*doped silicon 102 which forms a gate for the device. The layer 102 in the exemplary embodiment is a single crystal of silicon which has been highly doped to act as a back gate for the device, as conventionally known in the art. An insulative layer 104 of silicon dioxide SiO₂ is provided above the doped substrate 102 with a source electrode 106 provided above the layer 104 of silicon dioxide. A drain electrode 108 is provided above the layer 104 of silicon dioxide. The source electrode 106 and the drain electrode 108 are preferably comprised of metal such as titanium, molybdenum, or gold or alloys of those elements. The electrodes 106 and 108 may also be comprised of polysilicon which has been doped to function as a conductor. A carbon nanotube 110 (not drawn to scale) extends between the source electrode 106 and the drain electrode 108 with the carbon nanotube 110 in electrical contact both with the source electrode 106 and with the drain electrode 108.

The carbon nanotube field effect transistor (CNT FET) according to the present invention differs from the conventional carbon nanotube field effect transistor in that a carrier-trapping material 112 is provided for the nanotube. In the exemplary embodiment of Fig. 2, the carner-trapping material comprises molecules of oxygen molecules (O₂). The oxygen molecules is adsorbed by the nanotube 110 during fabrication of the CNT FET. The presence of the carrier-trapping material such as oxygen molecules suppresses electron injection from the drain electrode which changes the conventional CNT FET from an ambipolar device to a unipolar CNT FET device.

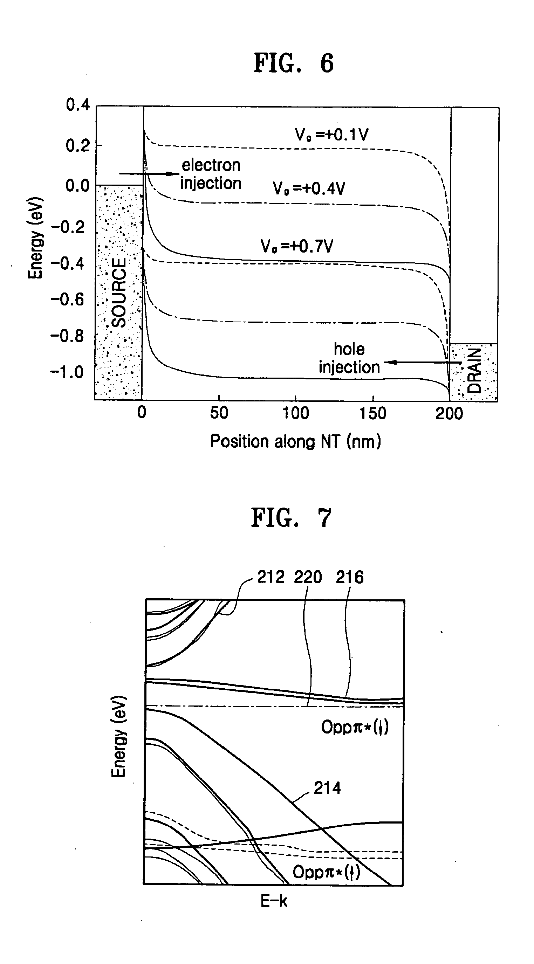

When a carrier-trapping material such as oxygen molecules is provided on the CNT (or nearby on the insulation layer or either on or in an additional layer adjacent to the CNT), the presence of the carrier-trapping material provides a LUMO (lowest unoccupied molecular level) roughly in the middle of the CNT energy gap (see also Figs. 6a-6c discussed below). (The LUMO level of the O₂ molecules is provided by the Oppπ* orbital level of the oxygen atom.) Accordingly, the oxygen molecules (or other carrier-trapping material) trap electrons from the drain electrode. As a result of the electron trappings, the whole band (both conduction band as well as valence band) moves up with respect to the metal work (or electrode) function. As a result, the energy barrier for electron injection increases which causes the CNT FET to be unipolar rather than ambipolar.

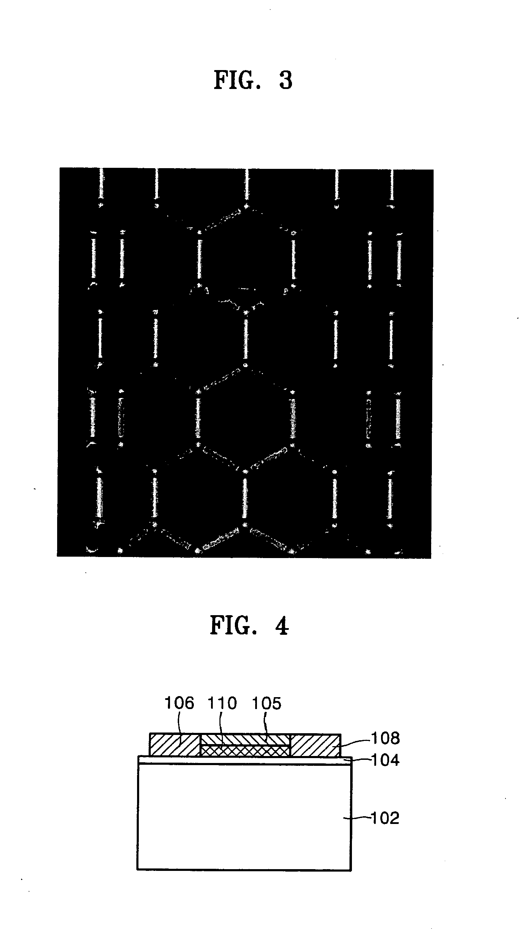

With reference to Fig. 3, during manufacture, the carbon nanotube is exposed to oxygen molecules (O₂) preferably under sufficient pressure to facilitate the adsorption of the oxygen molecules by the nanotube so that the oxygen molecules adhere to the carbon nanotube. Oxygen molecules are stable up to about 200°C which may be unsuitable for some semiconductor fabrication steps. The carrier-trapping material may be another material besides oxygen molecules (with a higher temperature level tolerance) so long as the material has a LUMO (lowest unoccupied molecular level) which is within the band gap of the channel material, i.e., roughly equal to the Fermi level of the CNT.

As shown in Fig. 2 (and in Fig. 1), the channel between the source and drain is provided by the carbon nanotube instead of by a silicon single crystal. Although the carbon nanotube and the source and drain electrodes are provided above the gate, the present invention is applicable to devices in which the source and drain electrodes are provided below the gate and where the carbon nanotube is buried within the device structure. Likewise, the substrate of the CNT FET could be a layer of silicon with a separate gate provided above the source and drain electrodes or with a multi-gate arrangement as conventionally known for CNT FETs.

The source and drain electrodes are typically comprised of metal(s) although the source and drain electrodes could also be comprised of polysilicon which has been sufficiently doped to function as a conductor. The substrate which forms the gate 102 is typically comprised of silicon although the substrate may be comprised of any material which provides a gate for the CNT FET. Likewise, the oxide layer 104 above the gate 102 is preferably comprised of silicon dioxide although the oxide layer may be comprised of any suitable insulative material, and preferably of an oxide material. In the same way, the nanotube is preferably comprised of carbon as conventionally known although the nanotube may be comprised of other materials.

With reference to Fig. 3, the adsorption of oxygen molecules by the carbon nanotube is illustrated with the individual atoms of oxygen held by adjacent atoms of carbon in the nanotube. As will be explained further below, the oxygen atoms facilitate carrier-trapping in the nanotube. Although in the exemplary embodiment, the carrier-trapping material such as oxygen molecules is adsorbed by the nanotube, the carrier-trapping material may also be adsorbed by the insulative layer 104, such as the layer of SiO₂. The oxygen molecules may be adsorbed on the surface of the CNT as well as on the inside of the CNT. In addition, the carrier-trapping material such as oxygen molecules may be adsorbed on the insulative layer of SiO₂ which is physically near to the CNT and thereby render the device unipolar. With reference to Fig. 4, the carrier-trapping material may also be provided in an additional layer 105 which is applied as a spin-coat on the device or which is deposited in any suitable conventional way for semiconductor device fabrication.

The carrier-trapping material may be provided in the material of the additional layer 105 as applied to the device or the carrier-trapping material may be adsorbed by the layer in a subsequent processing step during fabrication. The additional layer 105 may be comprised of any suitable material which can adsorb or contain the carrier-trapping material, such as oxygen molecules. The additional layer 105 may be a protective layer for the device, especially a layer which is applied during a relatively low temperature fabrication process

In a exemplary embodiment wherein the carrier trapping material is adsorbed or contained by the oxide layer or by an additional layer (rather than by the nanotube 110), it is exemplary that the gap between the CNT and the material with the carrier-trapping material be less than about 1 nm (i.e., less than the quantum length of electron travel).

With continued reference to Fig. 4, the additional layer of material 105 may be provided during manufacture of the CNT FET either physically above or below the carbon nanotube or both (i.e., to enclose the nanotube). The additional layer 105 may also be provided either before or after the carbon nanotube has been provided between the source electrode 106 and the drain electrode 108.

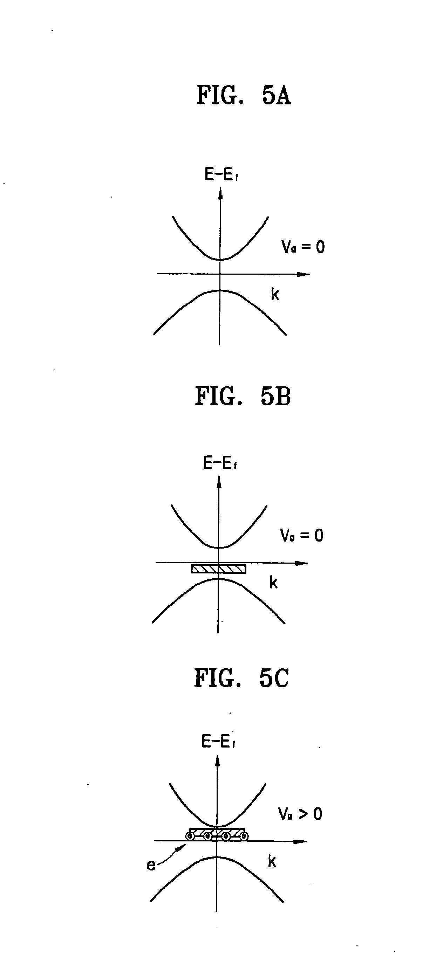

With reference now to Fig. 5a, a graph of the Energy-K (i.e., the wave vector) at zero gate voltage is shown in a conventional CNT FET (i.e., without the use of a carrier-trapping material such as oxygen molecules). The lower curve represents the HOMO (or highest occupied molecular level) and the upper curve represents the LUMO (or lowest unoccupied molecular level) for the CNT channel in a conventional CNT FET.

In Fig. 5b, a graph of the Energy-K (i.e., the wave vector) at zero gate voltage is shown in a CNT FET according to an embodiment of the present invention in which a carrier-trapping material such as oxygen molecules has been adsorbed by the CNT.

In Fig. 5c, when the gate voltage is increased, the presence of the carrier-trapping material accepting electrons raises the curve representing the HOMO as well as raising the curve representing the LUMO. The electrons trapped at the carrier-trapping material make the trapped energy level higher than the Fermi level.

With reference now to Fig. 6, the energy of electron injection at different gate voltages is plotted as a function of position along the carbon nanotube. As noted above, CMOS devices and logic gates which comprise CNT FETs generally require either n or p transistor devices (i.e., devices which are unipolar) and which operate at the same gate bias. Conventional CNT FETs, however, demonstrate ambiopolar characteristics as a result of the injection of carriers from a lowering of the barriers in either the source or the drain. In Fig. 6, the band alignment at different bias conditions of the gate are shown. The energy of a hole injection is plotted at different voltages as a function of position along the carbon nanotube. The energy is provided in electron-volts (eV) and the position is shown in nanometers (nm).

With reference now to Fig. 7, Fermi level 220 of the CNT is shown as a dashed line between the LUMO level 212 of the CNT and the HOMO level 214 of the CNT. The LUMO level 216 of the oxygen molecules is roughly midway between the LUMO level 212 and the HOMO level 214 of the CNT.

In a method of fabrication according to embodiments of the present invention, a nanotube field effect transistor is converted from an ambipolar device to a unipolar device by providing a carrier-trapping material such as oxygen molecules for the nanotube. The carrier-trapping material is preferably adsorbed by the nanotube by subjecting the nanotube to oxygen molecules under suitable pressure and at a temperature which facilitates the adsorption of the material by the nanotube.

During fabrication of the nanotube field effect transistor, the carrier-trapping material may be provided in the insulative layer of the device (such as a layer of SiO₂). Alternatively (or in addition thereto) another layer can be spun-on or deposited above or below the CNT during fabrication of the device. If the carrier-trapping material is not provided in the additional layer during fabrication, then the device is again exposed to the carrier-trapping material (such as O₂) during fabrication to enable the carrier-trapping material to be adsorbed by the additional layer. Preferably, the insulative layer or additional layer containing the carrier-trapping material is close to or touching the CNT so that any gap between the CNT and the material containing the carrier-trapping material is less than about 1 nanometer (or the quantum length of electron travel).

While the present invention has been particularly shown and described with reference to exemplary embodiments thereof, the structure of a nanotube field effect transistor according to the present invention may be varied by a person skilled in the art without departing from the scope of the present invention as defined by the following claims.

## Claims

1. A field effect transistor, comprising:
a source electrode;
a drain electrode;
a gate;
an insulator layer separating said gate from both said source electrode and said drain electrode;
a nanotube provided in electrical contact with said source electrode and said drain electrode, said nanotube acting as a channel region of said field effect transistor; and
a carrier-trapping material for said nanotube.

2. The field effect transistor of claim 1, wherein said carrier-trapping material is oxygen molecules.

3. The field effect transistor of claim 1 or 2, further comprising an additional layer of material between said insulator layer and said nanotube, said additional layer of material containing said carrier-trapping material for said nanotube.

4. The field effect transistor of any preceding claim, wherein said carrier-trapping material converts said field effect transistor from an ambipolar device to a unipolar device.

5. The field effect transistor of any preceding claim, wherein said gate comprises a substrate for the field effect transistor with said insulator layer being provided above said substrate and with said source electrode, said drain electrode, and said nanotube being provided above said insulator layer, said nanotube extending between said source electrode and said drain electrode.

6. The field effect transistor of claim 5, wherein said substrate has been doped to act as a back gate.

7. The field effect transistor of claim 6, wherein said source electrode and said drain electrode are made from a material selected from the group consisting of one or more of Ti and Mo.

8. The field effect transistor of any preceding claim, wherein said insulation layer is disposed on said nanotube, and said gate is disposed on said insulation layer.

9. The field effect transistor of any preceding claim, further comprising an additional layer of material between said insulator layer and said nanotube, said additional layer of material containing said carrier-trapping material for said nanotube.

10. The field effect transistor of claim 9, wherein said source electrode and said drain electrode are made from a material selected from the group consisting of one or more of Ti and Mo.

11. The field effect transistor of any of claims 1 to 8, wherein said carrier-trapping material is adsorbed on said nanotube.

12. A method of converting an ambipolar nanotube field effect transistor to a unipolar nanotube field effect transistor, wherein said nanotube field effect transistor includes a source electrode, a drain electrode, a gate, an insulator layer separating said gate from both said source electrode and said drain electrode, and a nanotube provided in electrical contact with said source electrode and said drain electrode, said nanotube acting as a channel region of said field effect transistor, said method comprising providing a carrier-trapping material for said nanotube.

13. The method of claim 12, wherein the step of providing a carrier-trapping material for said nanotube includes adsorbing the carrier-trapping material by said nanotube.

14. The method of claim 12 or 13, wherein said carrier-trapping material is oxygen molecules.

15. The method of claim 12, 13 or 14, wherein the step of providing a carrier-trapping material for said nanotube includes providing a layer of material between said insulator layer and said nanotube, said layer of material including said carrier-trapping material for said nanotube.

16. The method of any of claims 12 to 15, wherein the step of providing a carrier-trapping material for said nanotube includes causing a surface near said nanotube to adsorb said carrier-trapping material.

17. A method of making a field effect transistor, comprising the steps of:
providing a substrate;
forming an insulative layer above said substrate;
forming a source electrode above the insulative layer;
forming a drain electrode above the insulative layer;
providing a nanotube between the source electrode and the drain electrode with the nanotube being in functional contact with said source electrode and said drain electrode, said nanotube acting as a channel region of said field effect transistor, said method comprising providing a carrier-trapping material for said nanotube.

18. The method of claim 17, wherein the step of providing a carrier-trapping material for said nanotube includes absorbing the carrier-trapping material by said nanotube.

19. The method of claim 17 or 18, wherein said carrier-trapping material is oxygen molecules.

20. The method of any of claims 17 to 19, wherein said substrate is doped to act as a back gate for said field effect transistor.

21. The method of any of claims 17 to 20, wherein the step of providing a carrier-trapping material for said nanotube includes providing a layer of material between said insulator layer and said nanotube, said layer of material including said carrier-trapping material for said nanotube.

22. The method of any of claims 17 to 21, wherein the step of providing a carrier-trapping material for said nanotube includes causing a surface near said nanotube to adsorb said carrier-trapping material.
